# EUROPÄISCHE PATENTSCHRIFT

(11) **EP 3 821 259 B1**
(45) Veröffentlichungstag und Bekanntmachung des Hinweises auf die Patenterteilung: **03.01.2024**
(21) Anmeldenummer: 19737055.4
(22) Anmeldetag: 03.07.2019
(51) Int. Cl.: G01R 15/06, H01G 4/01, H01G 4/18, H01G 17/00

(54) **SPANNUNGSTEILUNGSVORRICHTUNG MIT SILOXAN-DIELEKTRIKUM**
VOLTAGE-DIVIDING DEVICE HAVING A SILOXANE DIELECTRIC
DISPOSITIF DIVISEUR DE TENSION COMPRENANT UN DIÉLECTRIQUE À BASE DE SILOXANE

(30) Priorität: 11.07.2018 AT 505942018
(43) Veröffentlichungstag der Anmeldung: 19.05.2021
(73) Patentinhaber: Greenwood-Power GmbH, 2471 Rohrau (AT)
(72) Erfinder: JUSCHICZ, Norbert, 2404 Petronell-Carnuntum (AT); BACHER, Willibald, 2404 Petronell-Carnuntum (AT)
(74) Vertreter: Puchberger & Partner Patentanwälte
(86) Internationale Anmeldenummer: PCT/EP2019/067855
(87) Internationale Veröffentlichungsnummer: WO 2020/011619

(56) Entgegenhaltungen:
- EP-A1- 3 223 024
- WO-A1-99/15906
- US-A1- 2015 200 245
- US-A1- 2016 274 149

## Beschreibung

Die Erfindung betrifft eine Spannungsteilungsvorrichtung gemäß dem Oberbegriff der unabhängigen Patentansprüche.

Spannungsteilungsvorrichtungen, auch als Spannungsteiler bekannt, werden in Schaltanlagen von Stromnetzen bei der Messung der Spannung eingesetzt. Durch das vermehrte Einbringen von Energie aus verschiedenartigen Quellen, wie beispielsweise Solarenergie oder Windenergie, in Stromnetze, wird die Bestimmung und Überwachung von bestimmten Leistungsparametern des Stromnetzes immer wichtiger. Hierzu zählt unter anderem die tatsächliche Netzspannung.

Im Stand der Technik werden bei der Messung oft sogenannte konventionelle Wandler eingesetzt. Dies sind üblicherweise induktive Spannungsteiler mit einem ferromagnetischen Eisenkern, welche eine hohe Anfälligkeit gegenüber Störeinflüssen aufweisen. Als Alternative sind sogenannte nichtkonventionelle Wandler bekannt, welche im Wesentlichen in die Basistechnologien der ohmschen Spannungsteiler, der ohmsch-kapazitiven Spannungsteiler und der kapazitiven Spannungsteiler klassifiziert werden können.

Ohmsche Spannungsteiler arbeiten mit einem oder mehreren elektrischen Widerständen, haben jedoch den wesentlichen Nachteil, dass beispielsweise vom Verbindungskabel oder von den weiteren Bauelementen stammende Streukapazitäten und/oder parasitische Kapazitäten einen großen Einfluss auf den tatsächlichen Messwert und somit auf die Messgenauigkeit haben. Als Weiterbildung derartiger ohmscher Spannungswandler sind ohmsch-kapazitive Spannungsteiler bekannt, welche im Wesentlichen wenigstens einen elektrischen Widerstand und einen elektrischen Kondensator mit definierter Kapazität aufweisen.

Ist die Kapazität des Kondensators hinreichend groß, werden oben genannte Streukapazitäten und parasitische Kapazitäten vernachlässigbar klein und die Messgenauigkeit wird erhöht.

Ein Hauptproblem derartiger ohmsch-kapazitiver Spannungsteiler ist, dass die Kapazität des Kondensators über lange Zeiträume - in der Regel mehrere Jahren oder sogar Jahrzehnte - möglichst konstant bleiben soll, um ein Driften des tatsächlichen Messwerts zu vermeiden. Ferner ist eine Konstanz der Kapazität des Kondensators bei Veränderungen der Außentemperatur oder bei geringfügiger Änderung der Frequenz des Stromes notwendig. Zusätzlich kann die Aufnahme von Feuchtigkeit in das zwischen den Kondensatorelementen befindliche Dielektrikum während der Lebensdauer des Spannungsteilers zu einer Veränderung der Kapazität führen.

Typischerweise wird als Dielektrikum im Stand der Technik ein Epoxidgießharz eingesetzt, in welches die Kondensatorelemente und der elektrische Widerstand des Spannungsteilers eingegossen sind. Die Kondensatoranordnungen bekannter Spannungsteilungsvorrichtungen sind beispielsweise als zwei konzentrisch angeordnete, ringförmige Kondensatorelemente ausgebildet.

Wasseraufnahme in das Dielektrikum durch Diffusion von Wasserdampf aus der Luftfeuchtigkeit stellt ein Problem dar, da hierdurch die Kapazität herkömmlicher Kondensatoranordnungen beeinflusst wird, was bei einem langjährigen Betrieb einer Spannungsteilungsvorrichtung, insbesondere unter vor Luftfeuchtigkeit und Temperaturschwankungen ungeschützten Bedingungen, zu einem Drift der Kapazität führen kann, was eine direkte Beeinflussung der Genauigkeit des Messwerts zur Folge hat. Auswirkungen von Temperaturschwankungen auf die Messgenauigkeit werden stärker, je mehr Feuchtigkeit in den Bereich des Kondensators vorgedrungen ist. Dabei ist die Kapazität des Kondensators abhängig von der Feuchte des Dielektrikums, der Temperatur und der Frequenz des Stroms.

Die EP 3223024 A1 offenbart unter anderem die Verwendung eines Silikongels als Dielektrikum, wobei auch die Verwendung dieses Materials zu hohen Kapazitätsdrifts führen kann, wenn seine Eigenschaften nicht geeignet gewählt sind.

Es ist die Aufgabe der vorliegenden Erfindung, die Nachteile des Standes der Technik zu überwinden und eine Spannungsteilungsvorrichtung zu schaffen, die über einen langen Zeitraum, insbesondere über mehrere Jahre oder Jahrzehnte, eine konstante Kapazität aufweist.

Die Aufgabe der Erfindung wird durch die kennzeichnenden Merkmale der unabhängigen Patentansprüche gelöst.

Eine erfindungsgemäße Spannungsteilungsvorrichtung umfasst einen Kernbereich mit einer im Kernbereich angeordneten Kondensatoranordnung und einen im Kernbereich angeordneten elektrischen Widerstand. Eine erste Elektrode der Kondensatoranordnung verfügt über ein Koppelteil, wobei ein spannungsführendes Element über das Koppelteil mit der Spannungsteilungsvorrichtung elektrisch leitend verbindbar ist. Eine zweite Elektrode der Kondensatoranordnung verfügt über ein Erdungsteil, wobei eine Erdung über das Erdungsteil mit der Spannungsteilungsvorrichtung elektrisch leitend verbindbar ist. Die erste Elektrode und die zweite Elektrode sind elektrisch leitend über den elektrischen Widerstand verbunden.

Erfindungsgemäß ist vorgesehen, dass der Kernbereich ein Dielektrikum umfasst, welches ein Siloxan-basiertes Polymer umfasst oder aus einem Siloxan-basierten Polymer besteht.

Siloxan-basierte Polymere, insbesondere feste Siloxan-Polymere, auch als Silikon-Polymere bekannt, weisen diffusionshemmende Eigenschaften auf. Derartige Polymere als Dielektrikum sind weitestgehend unempfindlich gegenüber Wasserdampfdiffusion und es zeigen sich keine nennenswerten Veränderungen der Dielektrizitätskonstante, wenn diese Luftfeuchtigkeit ausgesetzt werden. Ferner ist das Frequenzübertragungsverhalten von Silikon-Polymeren im Vergleich zu bekannten Dielektrika besser, womit normgerechte Anforderungen, insbesondere betreffend den internationalen Standard IEC 60044-7, erfüllt werden können. Zusätzlich können innerhalb der vorgegebenen Grenzen bis zu 10 kHz übertragen werden.

Siloxan-basierte Polymere, insbesondere feste Siloxan-Polymere, auch als Silikon-Polymere bekannt haben elastische Eigenschaften. In einer erfindungsgemäßen Spannungsteilungsvorrichtung kann sich das Polymer dadurch gut an die Struktur der Elektrodenanordnung anpassen. Bei unelastischen Materialien können beispielsweise bei Temperaturschwankungen im Material Risse auftreten oder das Material der Kondensatoranordnung kann sich wenigstens teilweise vom Dielektrikum lösen. Dies kann zu einer Bildung von gasgefüllten Hohlräumen führen, welche einerseits eine Konstanz der Kapazität der Kondensatoranordnung verhindern und andererseits zu Spannungsüberschlägen und einer nur unvollständigen Entladung der Spannungsteilungsvorrichtung führen können. Diese Probleme können mit einem Siloxan-basierten Polymer vermieden werden, da eine gute Verbindung mit den Elementen der Kondensatoranordnung gewährleistet wird.

Gegebenenfalls kann vorgesehen sein, dass der Kernbereich im Wesentlichen kegelstumpfförmig oder im Wesentlichen zylinderförmig ausgebildet ist. Gegebenenfalls kann vorgesehen sein, dass ein Mantelbereich, vorzugsweise ein Mantelbereich aus Epoxid-basiertem Polymer, vorgesehen ist, der den Kernbereich zumindest teilweise, vorzugsweise komplett, umgibt.

Aufgrund der typischen elastischen Eigenschaften von Siloxan-Polymeren kann es vorteilhaft sein, den aus Siloxan-Polymer gebildeten Kernbereich von einem mechanisch stabileren Mantelbereich zu umgeben und dadurch vor Verformung und Zerstörung zu schützen.

Gegebenenfalls kann vorgesehen sein, dass das Dielektrikum des Kernbereichs eine relative Dielektrizitätskonstante von 4 bis 6 aufweist.

Gegebenenfalls kann vorgesehen sein, dass sich die relative Dielektrizitätskonstante des Dielektrikums des Kernbereichs in einem Temperaturbereich von -40°C bis 80°C im Vergleich zur relativen Dielektrizitätskonstante des Dielektrikums bei 20°C um höchstens 3%, vorzugsweise um höchstens 0,75%, verändert.

Da der Einsatzbereich der erfindungsgemäßen Spannungsteilungsvorrichtung üblicherweise in nicht klimatisierten oder geheizten Bereichen ist, ist es vorteilhaft, wenn die Dielektrizitätskonstante des Dielektrikums in einem typischerweise unter normalen Umweltbedingungen auftretenden Temperaturbedingungen möglichst konstant ist. Dadurch wird eine gleichmäßige Kapazität der Kondensatoranordnung gewährleistet, was für eine möglichst genaue Spannungsmessung von Vorteil ist.

Gegebenenfalls kann vorgesehen sein, dass sich die relative Dielektrizitätskonstante des Dielektrikums des Kernbereichs in einem Frequenzbereich von 50 Hz bis 10000 Hz im Vergleich zur relativen Dielektrizitätskonstante des Dielektrikums bei 50 Hz um höchstens 0,6%, vorzugsweise um höchstens 0,4%, verändert.

Durch die Einspeisung verschiedenartiger Energiequellen kann es in modernen Stromnetzen zu einer Variation der Netzfrequenz kommen. Deshalb ist es vorteilhaft, wenn die Dielektrizitätskonstante des Dielektrikums auch in einem für Stromnetze typischen Frequenzbereich konstant ist, um eine exakte Messung der Spannung zu gewährleisten.

Gegebenenfalls kann vorgesehen sein, dass sich die relative Dielektrizitätskonstante des Dielektrikums des Kernbereichs bei einem Wasseranteil des Dielektrikums von 5‰ bis 30‰ um höchstens 3%, vorzugsweise um höchstens 2,9% im Vergleich zur relativen Dielektrizitätskonstante des Dielektrikums bei einem Wassergehalt von 30‰, verändert.

Da die erfindungsgemäße Spannungsteilungsvorrichtung typischerweise unter normalen Umweltbedingungen verwendet wird, kann es auch vorkommen, dass diese erhöhter Luftfeuchtigkeit ausgesetzt ist. Siloxan-basierte Polymere weisen üblicherweise eine geringe Wasseraufnahmefähigkeit auf. Dennoch ist es vorteilhaft, wenn die Dielektrizitätskonstante des Dielektrikums über einen gewissen Bereich des Wassergehalts möglichst konstant ist, um auch über lange Zeiträume hinweg konstante Messergebnisse für die Spannung zu erzielen. Insbesondere würde eine starke Abhängigkeit der Dielektrizitätskonstante vom Wassergehalt des Dielektrikums zu einem unerwünschten zeitlichen Drift des Messwertes führen, wenn mit der Betriebsdauer der Spannungsteilungsvorrichtung immer mehr Wasser in das Dielektrikum eindiffundiert.

Gegebenenfalls kann vorgesehen sein, dass der Kernbereich aus einem zweikomponentigen, heißhärtenden Siloxan-System vergossen wird.

Erfindungsgemäß ist vorgesehen, dass die maximale Wasseraufnahmefähigkeit bei einer Temperatur von 20°C 30‰ des Eigengewichtes der Polymermasse beträgt. Die maximale Wasseraufnahmefähigkeit kann beispielsweise durch Lagern des Silikon-Polymers für etwa 1000 Tage in einer Klimakammer bestimmt werden.

Die Erfindung betrifft ferner eine Anordnung einer erfindungsgemäßen Spannungsteilungsvorrichtung an einem Verbindungsteil einer Schaltanlage eines Stromnetzes.

Die Erfindung betrifft ferner ein Verfahren zur Herstellung einer erfindungsgemäßen Spannungsteilungsvorrichtung, welches die folgenden Schritte umfasst:
- Gießen des Kernbereichs aus einer Siloxan-basierten Gussmasse, insbesondere aus einer Zweikomponenten-Gussmasse und
- Aushärten des Kernbereichs.

Gegebenenfalls kann das Verfahren die folgenden Schritte umfassen:
- Gießen des Mantelbereichs aus einer Gussmasse, insbesondere aus einer Epoxid-basierten Gussmasse und
- Aushärten des Mantelbereichs.

Gegebenenfalls ist vorgesehen, dass die erste Elektrode und die zweite Elektrode mehrere elektrisch leitende, im Wesentlichen fingerförmige oder stabförmige, Aussteuerungselemente umfassen.

Durch die fingerförmige oder stabförmige Ausgestaltung der Aussteuerungselemente wird die Möglichkeit der Bildung von Ablösungen und damit das Vorhandensein von gasgefüllten Hohlräumen beispielsweise durch Schrumpfen des Dielektrikums während des Herstellungsprozesses der Spannungsteilungsvorrichtung reduziert. Ferner können sich die stabförmigen Aussteuerungselemente leichter an Temperaturschwankungen anpassen, was bei ringförmigen Elektrodenanordnungen nicht der Fall ist. Im Wesentlichen können die fingerförmigen oder stabförmigen Aussteuerungselemente im Produktionsprozess und bei Temperaturschwankungen mit dem dielektrischen Medium "mitwandern".

Gasgefüllte Hohlräume erhöhen das Potenzial von Spannungsüberschlägen und verhindern die vollständige Entladung der Spannungsteilungsvorrichtung, was für einen zuverlässigen Betrieb unerwünscht ist. Dies ist insbesondere wichtig, wenn die Kondensatoranordnung in einem festen Dielektrikum eingebettet ist, beziehungsweise der Kernbereich wird durch ein festes Dielektrikum ausgefüllt ist. Gegebenenfalls kann dazu ein den Kernbereich ausfüllendes Polymer vorgesehen sein.

Gegebenenfalls ist vorgesehen, dass die Aussteuerungselemente der ersten Elektrode und der zweiten Elektrode zueinander im Wesentlichen konzentrisch kreisförmig angeordnet sind.

Dadurch wird eine möglichst große Kondensatorfläche bei geringem Platzbedarf ermöglicht. Durch eine Anordnung in konzentrischen Kreisen kann zusätzlich der Abstand zwischen den Kondensatorelementen konstant bleiben.

Gegebenenfalls ist vorgesehen, dass der Radius der Anordnung der Aussteuerungselemente der außenliegenden Elektrode um etwa 50% größer ist als der Radius der Anordnung der Aussteuerungselemente der innenliegenden Elektrode.

Gegebenenfalls ist vorgesehen, dass der Radius der Anordnung der Aussteuerungselemente der innenliegenden Elektrode zwischen 8 mm und 22 mm beträgt, und dass der Radius der Anordnung der Aussteuerungselemente der außenliegenden Elektrode zwischen 15 mm und 40 mm beträgt.

Ist der Abstand zwischen den Aussteuerungselementen groß genug, kann die Gefahr von Spannungsüberschlägen zwischen den Aussteuerungselementen und eine damit verbundene etwaige Beschädigung des Dielektrikums verhindert werden. Eine Anpassung des Abstandes kann in Abstimmung mit den Betriebsbedingungen, insbesondere in Abstimmung mit der Eingangsspannung, erfolgen.

Gegebenenfalls ist vorgesehen, dass die Aussteuerungselemente eine Länge von 10 mm bis 60 mm aufweisen, und dass die Aussteuerungselemente einen Durchmesser von 1,5 mm bis 10 mm aufweisen.

Gegebenenfalls ist vorgesehen, dass die Aussteuerungselemente einen im Wesentlichen elektrisch isolierenden Grundkörper und eine elektrisch leitende Beschichtung aufweisen.

Gegebenenfalls ist vorgesehen, dass die Aussteuerungselemente ein elektrisch leitendes Additiv und eine im Wesentlichen elektrisch isolierende Grundmasse umfassen.

Durch die Verwendung eines elektrisch isolierenden Grundkörpers bzw. durch die Hinzufügung eines elektrisch leitenden Additivs zu einer im Wesentlichen elektrisch isolierenden Grundmasse können die Ausdehnungskoeffizienten von Dielektrikum und Aussteuerungselementen aneinander angenähert werden. Dadurch werden die Ablösung der Aussteuerungselemente und die damit verbundene unerwünschte Hohlraumbildung weiter reduziert. Vorzugsweise wird als Grundkörper bzw. als Grundmasse ein Epoxidharz eingesetzt. Insbesondere im Vergleich zu vollmetallischen Aussteuerungselementen kann so die Hohlraumbildung stark reduziert werden.

Gegebenenfalls ist vorgesehen, dass das Additiv Kohlenstoff-Nanopartikel umfasst oder aus Kohlenstoff-Nanopartikeln besteht.

Gegebenenfalls ist vorgesehen, dass die Längsausdehnungsrichtung der Aussteuerungselemente der ersten Elektrode und die Längsausdehnungsrichtung der Aussteuerungselemente der zweiten Elektrode im Wesentlichen parallel verlaufen.

Damit kann ein im Wesentlichen durchgehend konstanter Abstand zwischen den Aussteuerungselementen erreicht werden. Dies kann insbesondere eine konstante Kapazität der Kondensatoranordnung begünstigen.

Gegebenenfalls ist vorgesehen, dass die Aussteuerungselemente der ersten Elektrode und der zweiten Elektrode in einer Richtung parallel ihrer Längsausdehnungsrichtung einen Überlappungsbereich aufweisen. Durch die Breite des Überlappungsbereichs kann die Kapazität der Kondensatoranordnung bestimmt werden.

Gegebenenfalls ist vorgesehen, dass die erste Elektrode sechs bis vierzehn, vorzugsweise acht bis zwölf, Aussteuerungselemente aufweist, und dass die zweite Elektrode 14 bis 26, vorzugsweise 18 bis 22, Aussteuerungselemente aufweist.

Gegebenenfalls ist vorgesehen, dass die Kondensatoranordnung eine Kapazität von 1 pF bis 30 pF, vorzugsweise von 1 pF bis 15 pF, bei einer Temperatur von 20°C, einer relativen Luftfeuchtigkeit von 50%, einem Druck von 1000 mbar und einer Stromfrequenz von 50 Hz aufweist.

Eine ausreichend große Kapazität der Kondensatoranordnung ermöglicht die Vernachlässigung von Streukapazitäten und parasitischen Kapazitäten bei der Spannungsmessung. Dadurch werden die genannten Restkapazitäten im Vergleich zur Hauptkapazität des Kondensators so gering, dass diese keinen wesentlichen Einfluss mehr auf die Genauigkeit der Messung haben.

Weitere Merkmale der Erfindung ergeben sich aus den Patentansprüchen, den Ausführungsbeispielen sowie aus den Figuren.

Im Folgenden wird die Erfindung anhand eines nicht erschöpfenden Ausführungsbeispiels im Detail erläutert.

Es zeigen:
Fig. 1 eine seitliche Schnittansicht einer erfindungsgemäßen Spannungsteilungsvorrichtung;
Fig. 2 eine Schnittansicht einer erfindungsgemäßen Spannungsteilungsvorrichtung entlang der Achse A-A aus Fig. 1.

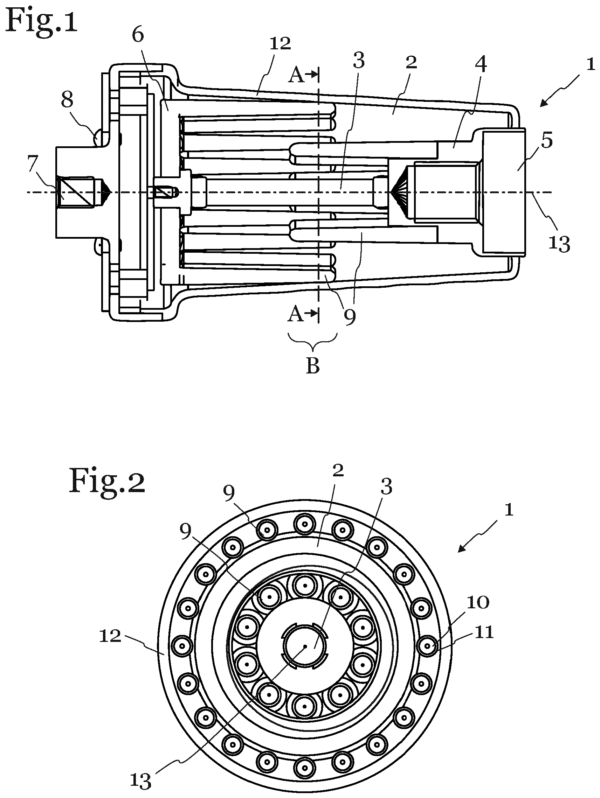

Fig. 1 zeigt eine erfindungsgemäße Spannungsteilungsvorrichtung 1 in einer Schnittansicht entlang einer Ebene, die durch eine Zentralachse 13 der Spannungsteilungsvorrichtung 1 verläuft. Dabei umfasst die Spannungsteilungsvorrichtung 1 eine Kondensatoranordnung, die eine erste Elektrode 4 und eine zweite Elektrode 6 umfasst. Die erste Elektrode 4 ist einstückig mit einem Koppelteil 5 ausgeführt, welches ein Gewinde umfasst und über dieses mit einem spannungsführenden Element verbindbar ist. Das spannungsführende Element kann gegebenenfalls eine Stromleitung in einem Verteilerkasten eines Stromnetzes sein. Die zweite Elektrode 6 ist einstückig mit einem Erdungsteil 7 ausgeführt, welches ebenfalls ein Gewinde zur Anbringung einer Erdung umfasst. Ferner umfasst die zweite Elektrode 6 einen Messanschluss 8, über welchen ein Messgerät zur Spannungsmessung verbindbar ist. Die erste Elektrode 4 und die zweite Elektrode 6 weisen in konzentrischen Kreisen angeordnete Aussteuerungselemente 9 auf, wobei die Aussteuerungselemente 9 fingerförmig ausgebildet sind.

Die fingerförmigen Aussteuerungselemente 9 der ersten Elektrode 4 und der zweiten Elektrode 6 weisen in diesem Ausführungsbeispiel zueinander im Wesentlichen parallele Längsausdehnungsrichtungen auf, wobei die Aussteuerungselemente 9 der ersten Elektrode 4 und die Aussteuerungselemente 9 der zweiten Elektrode 6 einen Überlappungsbereich B aufweisen.

Die erste Elektrode 4 und die zweite Elektrode 6 sind über einen elektrischen Widerstand 3 miteinander in elektrisch leitender Weise verbunden.

In diesem Ausführungsbeispiel sind Kondensatoranordnung und Widerstand 3 von einem Kernbereich 2 umgeben, welcher aus einem elastischen Material auf Siloxan-Polymerbasis gebildet wird. Da es sich bei dem Siloxan-Polymer in diesem Ausführungsbeispiel um ein elastisch-weiches Material handelt, ist der Kernbereich 2 zur Erhöhung der mechanischen Stabilität in diesem Ausführungsbeispiel von einer aus einem Epoxid-basierten Polymer bestehenden Mantelbereich 12 umgeben.

Das Siloxan-Polymer in diesem Ausführungsbeispiel weist im Vergleich zu typischerweise verwendeten Kunststoffmaterialien, wie etwa Epoxid-Polymeren eine geringe Wasserdiffusion auf.

Fig. 2 zeigt eine Schnittansicht der in Fig. 1 dargestellten Spannungsteilungsvorrichtung 1 entlang der Achse A-A. In Fig. 2 zeigt sich der im Wesentlichen konzentrische Aufbau der Elemente der erfindungsgemäßen Spannungsteilungsvorrichtung 1, insbesondere des elektrischen Widerstandes 3 im Zentrum verlaufend entlang der Zentralachse 13, sowie die Aussteuerungselemente 9 der ersten Elektrode 4 in einem inneren Kreis und die Aussteuerungselemente 9 der zweiten Elektrode 6 in einem äußeren Kreis.

In diesem Ausführungsbeispiel weisen die Aussteuerungselemente 9 einen im Wesentlichen elektrisch isolierenden Grundkörper 10 auf, welcher mit einer elektrisch leitenden Beschichtung 11, insbesondere mit einem Leitlack, beschichtet ist, um mit der ersten Elektrode 4 bzw. mit der zweiten Elektrode 6 in elektrisch leitender Weise in Verbindung zu stehen. In anderen Ausführungsbeispielen können die Aussteuerungselemente 9 auch vollständig aus elektrisch leitendem Material gebildet sein oder aus einem elektrischen Isolator, welcher durch Zugabe von Additiven elektrisch leitend ist.

In diesem Ausführungsbeispiel beträgt der Abstand zwischen den Radien der beiden Kreise, die die Anordnung der Aussteuerungselemente 9 der ersten Elektrode 4 und der zweiten Elektrode 6 beschreiben, etwa 7,6mm. In anderen Ausführungsbeispielen kann der Abstand jedoch auch andere Werte annehmen.

Die in diesem Ausführungsbeispiel beschriebene Spannungsteilungsvorrichtung 1 weist einen maximalen Isolationswert von 24 kV auf. In anderen Ausführungsbeispielen kann der maximale Isolationswert jedoch auch 36 kV betragen. Auch beliebige andere maximale Isolationswerte sind je nach Anwendungsbereich möglich.

Die Spannungsteilungsvorrichtung 1 gemäß diesem Ausführungsbeispiel ist für eine nominelle Spannung von maximal 24000/√3 V bei einer Frequenz von 50 Hz ausgelegt. Die Sekundär-Spannung beträgt in diesem Ausführungsbeispiel etwa 3,25/V3 V, kann jedoch in anderen Ausführungsbeispielen je nach Anwendung angepasst werden.

In diesem Ausführungsbeispiel ist der Responsefaktor der Spannungsteilungsvorrichtung, also insbesondere die Kapazität der Kondensatoranordnung in einem Temperaturbereich von -40°C bis 80°C konstant. Insbesondere beträgt die Kapazität der Kondensatoranordnung in diesem Ausführungsbeispiel 8 pF.

### Bezugszeichenliste

- 1: Spannungsteilungsvorrichtung
- 2: Kernbereich
- 3: Widerstand
- 4: erste Elektrode
- 5: Koppelteil
- 6: zweite Elektrode
- 7: Erdungsteil
- 8: Messanschluss
- 9: Aussteuerungselement
- 10: Grundkörper
- 11: Beschichtung
- 12: Mantelbereich
- 13: Zentralachse

- B: Überlappungsbereich

## Patentansprüche

1. Spannungsteilungsvorrichtung (1), umfassend
- einen Kernbereich (2) mit einer im Kernbereich (2) angeordneten Kondensatoranordnung und einen im Kernbereich (2) angeordneten elektrischen Widerstand (3),
- eine erste Elektrode (4) der Kondensatoranordnung mit einem Koppelteil (5) zur Verbindung mit einem spannungsführenden Element,
- eine zweite Elektrode (6) der Kondensatoranordnung mit einem Erdungsteil (7) zur Verbindung mit einer Erdung,
- und wobei die erste Elektrode (4) und die zweite Elektrode (6) elektrisch leitend über den elektrischen Widerstand (3) verbunden sind,
wobei der Kernbereich (2) ein Dielektrikum umfasst, welches ein Siloxan-basiertes Polymer umfasst oder aus einem Siloxan-basierten Polymer besteht, **dadurch gekennzeichnet, dass** die maximale Wasseraufnahmefähigkeit des Polymers bei einer Temperatur von 20°C 30‰ des Eigengewichtes der Polymermasse beträgt.

2. Spannungsteilungsvorrichtung nach Anspruch 1, **dadurch gekennzeichnet, dass** der Kernbereich (2) im Wesentlichen kegelstumpfförmig oder im Wesentlichen zylinderförmig ausgebildet ist.

3. Spannungsteilungsvorrichtung nach Anspruch 1 oder 2, **dadurch gekennzeichnet, dass** ein Mantelbereich (12), vorzugsweise ein Mantelbereich (12) aus Epoxid-basiertem Polymer, vorgesehen ist, der den Kernbereich (2) zumindest teilweise umgibt.

4. Spannungsteilungsvorrichtung nach einem der Ansprüche 1 bis 3, **dadurch gekennzeichnet, dass** das Dielektrikum des Kernbereichs (2) eine relative Dielektrizitätskonstante von 4 bis 6 aufweist.

5. Spannungsteilungsvorrichtung nach einem der Ansprüche 1 bis 4, **dadurch gekennzeichnet, dass** sich die relative Dielektrizitätskonstante des Dielektrikums des Kernbereichs (2) in einem Temperaturbereich von -40°C bis 80°C im Vergleich zur relativen Dielektrizitätskonstante des Dielektrikums bei 20°C um höchstens 3%, vorzugsweise um höchstens 0,75%, verändert.

6. Spannungsteilungsvorrichtung nach einem der Ansprüche 1 bis 5, **dadurch gekennzeichnet, dass** sich die relative Dielektrizitätskonstante des Dielektrikums des Kernbereichs (2) in einem Frequenzbereich von 50 Hz bis 10000 Hz im Vergleich zur relativen Dielektrizitätskonstante des Dielektrikums bei 50 Hz um höchstens 0,6%, vorzugsweise um höchstens 0,4%, verändert.

7. Spannungsteilungsvorrichtung nach einem der Ansprüche 1 bis 6, **dadurch gekennzeichnet, dass** sich die relative Dielektrizitätskonstante des Dielektrikums des Kernbereichs (2) bei einem Wasseranteil des Dielektrikums von 5‰ bis 30‰ um höchstens 3%, vorzugsweise um höchstens 2,9% im Vergleich zur relativen Dielektrizitätskonstante des Dielektrikums bei einem Wassergehalt von 30‰, verändert.

8. Spannungsteilungsvorrichtung nach einem der Ansprüche 1 bis 7, **dadurch gekennzeichnet, dass** der Kernbereich aus einem zweikomponentigen, heißhärtenden Siloxan-System vergossen wird.

9. Spannungsteilungsvorrichtung nach einem der Ansprüche 1 bis 8, umfassend fingerförmige oder stabförmige, an der ersten Elektrode (4) und an der zweiten Elektrode (6) angeordnete Aussteuerungselemente (9).

10. Anordnung einer Spannungsteilungsvorrichtung (1) nach einem der Ansprüche 1 bis 9 an einem Verbindungsteil einer Schaltanlage eines Stromnetzes.

11. Verfahren zur Herstellung einer Spannungsteilungsvorrichtung (1) nach einem der Ansprüche 1 bis 9, umfassend die Schritte:
- Gießen des Kernbereichs (2) aus einer Siloxan-basierten Gussmasse, insbesondere aus einer Zweikomponenten-Gussmasse
- Aushärten des Kernbereichs (2).

12. Verfahren nach Anspruch 11, zur Herstellung einer Spannungsteilungsvorrichtung (1) nach Anspruch 3, **dadurch gekennzeichnet, dass** das Verfahren zusätzlich die Schritte
- Gießen des Mantelbereichs (12) aus einer Gussmasse, insbesondere aus einer Epoxid-basierten Gussmasse und
- Aushärten des Mantelbereichs (12)
umfasst.

## Claims

1. A voltage division device (1), comprising
- a core region (2) with a capacitor arrangement arranged in the core region (2) and an electrical resistor (3) arranged in the core region (2),
- a first electrode (4) of the capacitor arrangement with a coupling member (5) for the connection with a live element,
- a second electrode (6) of the capacitor arrangement with a grounding member (7) for the connection with a grounding element,
- and wherein the first electrode (4) and the second electrode (6) are connected in an electrically conductive manner via the electrical resistor (3),
wherein the core region (2) comprises a dielectric which comprises a siloxane-based polymer or consists of a siloxane-based polymer, **characterised in that** the maximum water absorption capacity of the polymer at a temperature of 20 °C is 30 ‰ of the dead weight of the polymer mass.

2. The voltage division device according to claim 1, **characterised in that** the core region (2) has a substantially frustoconical or substantially cylindrical shape.

3. The voltage division device according to claim 1 or 2, **characterised in that** a sheath region (12), preferably a sheath region (12) made of epoxy-based polymer, is provided which at least partially surrounds the core region (2).

4. The voltage division device according to one of claims 1 to 3, **characterised in that** the dielectric of the core region (2) has a relative dielectric constant of 4 to 6.

5. The voltage division device according to one of claims 1 to 4, **characterised in that** the relative dielectric constant of the dielectric of the core region (2) in a temperature range of -40 °C to 80 °C changes by at most 3 %, preferably by at most 0.75 %, compared to the relative dielectric constant of the dielectric at 20 °C.

6. The voltage division device according to one of claims 1 to 5, **characterised in that** the relative dielectric constant of the dielectric of the core region (2) varies in a frequency range from 50 Hz to 10,000 Hz by at most 0.6 %, preferably by at most 0.4 %, compared to the relative dielectric constant of the dielectric at 50 Hz.

7. The voltage division device according to one of claims 1 to 6, **characterised in that** the relative dielectric constant of the dielectric of the core region (2) varies by at most 3 %, preferably by at most 2.9 %, at a water content of the dielectric of 5 ‰ to 30 ‰ compared to the relative dielectric constant of the dielectric at a water content of 30 ‰.

8. The voltage division device according to one of claims 1 to 7, **characterised in that** the core region is cast from a two-component, heat-curing siloxane system.

9. The voltage division device according to any one of claims 1 to 8, comprising finger-shaped or rod-shaped modulation elements (9) arranged on the first electrode (4) and on the second electrode (6).

10. An arrangement of a voltage division device (1) according to one of claims 1 to 9 on a connecting part of switchgear of a power grid.

11. A method for producing a voltage division device (1) according to any one of claims 1 to 9, comprising the steps of:
- casting the core region (2) from a siloxane-based casting compound, in particular a two-component casting compound,
- curing the core region (2).

12. The method according to claim 11, for producing a voltage division device (1) according to claim 3, **characterised in that** the method additionally comprises the steps of:
- casting the sheath region (12) from a casting compound, in particular from an epoxy-based casting compound, and
- curing the sheath region (12).

## Revendications

1. Dispositif de division de tension (1), comprenant
- une région de noyau (2) avec un agencement de condensateur disposé dans la région de noyau (2) et une résistance électrique (3) disposée dans la région de noyau (2),
- une première électrode (4) de l'agencement de condensateur ayant une partie de couplage (5) pour la connexion à un élément sous tension,
- une deuxième électrode (6) de l'agencement de condensateur ayant une partie de mise à la terre (7) pour la connexion à une mise à la terre,
- et dans lequel la première électrode (4) et la deuxième électrode (6) sont reliées de manière électriquement conductrice par l'intermédiaire de la résistance électrique (3),
dans lequel la région de noyau (2) comprend un diélectrique qui comprend un polymère à base de siloxane ou est constitué d'un polymère à base de siloxane, **caractérisé en ce que** la capacité maximale d'absorption d'eau du polymère à une température de 20 °C est de 30 ‰ du poids propre de la masse du polymère.

2. Dispositif de division de tension selon la revendication 1, **caractérisé en ce que** la région de noyau (2) est réalisée sensiblement en forme de cône tronqué ou sensiblement en forme de cylindre.

3. Dispositif de division de tension selon la revendication 1 ou 2, **caractérisé en ce qu'**il est prévu une région d'enveloppe (12), de préférence une région d'enveloppe (12) en polymère à base d'époxy, qui entoure au moins partiellement la région de noyau (2).

4. Dispositif de division de tension selon l'une des revendications 1 à 3, **caractérisé en ce que** le diélectrique de la région de noyau (2) présente une constante diélectrique relative de 4 à 6.

5. Dispositif de division de tension selon l'une des revendications 1 à 4, **caractérisé en ce que** la constante diélectrique relative du diélectrique de la région de noyau (2) varie d'au plus 3 %, de préférence d'au plus 0,75 %, dans une plage de température allant de -40 °C à 80 °C par rapport à la constante diélectrique relative du diélectrique à 20 °C.

6. Dispositif de division de tension selon l'une des revendications 1 à 5, **caractérisé en ce que** la constante diélectrique relative du diélectrique de la région de noyau (2) varie d'au plus 0,6 %, de préférence d'au plus 0,4 %, dans une plage de fréquences de 50 Hz à 10000 Hz par rapport à la constante diélectrique relative du diélectrique à 50 Hz.

7. Dispositif de division de tension selon l'une des revendications 1 à 6, **caractérisé en ce que** la constante diélectrique relative du diélectrique de la région de noyau (2) varie d'au plus 3 %, de préférence d'au plus 2,9 %, pour une teneur en eau du diélectrique comprise entre 5 ‰ et 30 ‰, par rapport à la constante diélectrique relative du diélectrique pour une teneur en eau de 30 ‰.

8. Dispositif de division de tension selon l'une des revendications 1 à 7, **caractérisé en ce que** la région de noyau est coulée à partir d'un système de siloxane thermodurcissable à deux composants.

9. Dispositif de division de tension selon l'une des revendications 1 à 8, comprenant des éléments de modulation (9) en forme de doigt ou de tige, disposés sur la première électrode (4) et sur la deuxième électrode (6).

10. Agencement un dispositif de division de tension (1) selon l'une des revendications 1 à 9 sur une partie de connexion d'un appareillage d'un réseau électrique.

11. Procédé de fabrication d'un dispositif de division de tension (1) selon l'une des revendications 1 à 9, comprenant les étapes consistant à
- couler la région de noyau (2) à partir d'une masse de coulée à base de siloxane, en particulier à partir d'une masse de coulée à deux composants,
- durcir de la région de noyau (2).

12. Procédé selon la revendication 11, pour la fabrication d'un dispositif de division de tension (1) selon la revendication 3, **caractérisé en ce que** le procédé comprend en outre les étapes consistant à :
- couler la région d'enveloppe (12) à partir d'une masse de coulée, en particulier à partir d'une masse de coulée à base d'époxyde, et
- durcir la région d'enveloppe (12).
